Europäisches Patentamt

(19) European Patent Office

Office européen des brevets

(11) Numéro de publication : **0 079 567**
**B1**

(12) **FASCICULE DE BREVET EUROPÉEN**

(45) Date de publication du fascicule du brevet :
**11.01.89**

(51) Int. Cl.⁴ : **C 30 B 15/00**, C 30 B 33/00,
C 30 B 29/06

(21) Numéro de dépôt : **82110316.5**

(22) Date de dépôt : **09.11.82**

(54) **Procédé de fabrication de feuilles de silicium polycristallin pour photopiles solaires.**

(30) Priorité : **13.11.81 FR 8121312**

(43) Date de publication de la demande :
**25.05.83 Bulletin 83/21**

(45) Mention de la délivrance du brevet :
**11.01.89 Bulletin 89/02**

(84) Etats contractants désignés :
**BE DE FR GB IT NL**

(56) Documents cités :
**FR--A-- 2 204 457**
**FR--A-- 2 317 005**
**JOURNAL OF CRYSTAL GROWTH, vol. 50, no. 1,
septembre 1980, pages 279-290, North-Holland
Publishing Co., Amsterdam, NL, C. BELOUET:
"Growth of polysilicon sheets by the RAD process."**

(73) Titulaire : **COMPAGNIE GENERALE D'ELECTRICITE
Société anonyme dite:
54, rue La Boétie
F-75382 Paris Cédex 08 (FR)**

(72) Inventeur : **Belouet, Christian
138, rue Houdan
F-92330 Sceaux (FR)**

(74) Mandataire : **Weinmiller, Jürgen et al
Lennéstrasse 9 Postfach 24
D-8133 Feldafing (DE)**

## Description

La présente invention concerne un procédé de fabrication de feuilles de silicium polycristallin pour photopiles solaires.

Par le brevet français publié sous le numéro 2 386 359 le 3 novembre 1978, on connaît un procédé qui consiste à faire circuler verticalement dans un bain de silicium un ruban de carbone traversant une fine ouverture disposée au fond d'un réservoir contenant le bain. On obtient ainsi une bande comprenant un support de carbone recouvert de silicium polycristallin. Cette bande est utilisée pour la réalisation de plaquettes de silicium, le support de carbone restant en place, en vue de la fabrication de photopiles solaires.

Ce procédé présente des inconvénients. En effet, les plaquettes réalisées à partir de bandes obtenues par ce procédé ont un rendement photoélectrique qui peut être limité par les caractéristiques du contact électrique entre le silicium et le support de carbone. De plus, elles conduisent à une technologie de réalisation de photopiles très spéciale compte tenu de la présence du support de carbone.

Par le document Journal Of Crystal Growth 50 (1980), pages 279-290, on connaît un procédé pour fabriquer des couches de silicium polycristallin pour des photopiles solaires consistant à déposer une couche de silicium sur un support et à éliminer ensuite ce support par un traitement mécanique.

L'invention a pour but de proposer un procédé économique de fabrication de feuilles de silicium polycristallin dépourvu d'un support et ainsi évitant le traitement mécanique pour l'élimination du support, traitement délicat et coûteux. Ce but est atteint par le procédé tel qu'il est défini dans la revendication 1. Les revendications 2-9 se rapportent à des modes de réalisation particuliers du procédé selon la revendication 1.

Des modes particuliers de mise en œuvre du procédé selon l'invention sont décrits ci-dessous, à titre d'exemple, en référence aux dessins annexés dans lesquels :

— la figure 1 représente schématiquement un dispositif connu en soi, permettant de réaliser une bande composée d'un support de carbone recouvert d'une mince pellicule de silicium

— et la figure 2 est une vue représentant partiellement une telle bande après une opération de découpe.

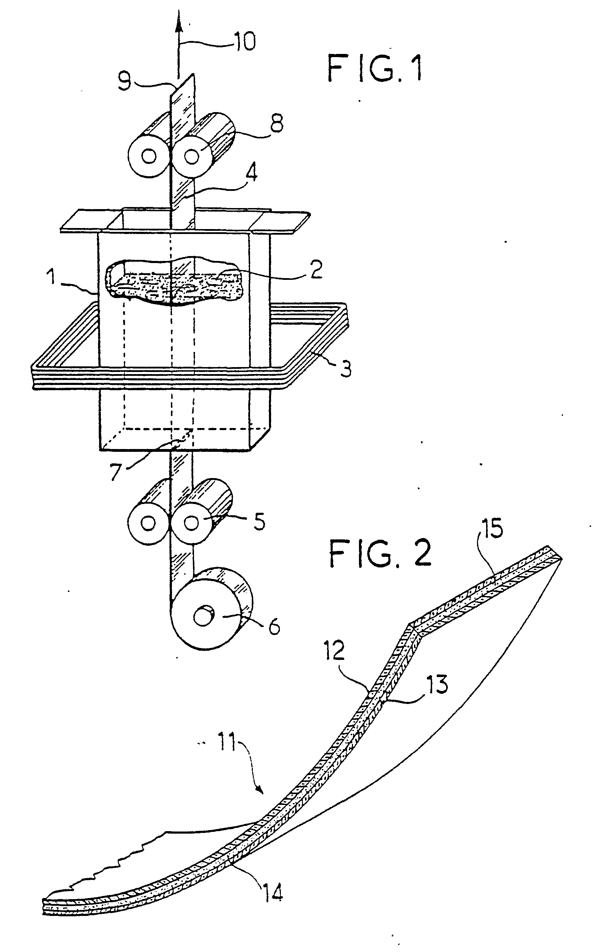

Sur la figure 1, est représenté un récipient 1 contenant un bain 2 de silicium porté à l'état liquide par des moyens de chauffage 3. Le fond du récipient 1 est muni d'une fine ouverture 7 à travers laquelle passe verticalement un ruban de carbone 4, par exemple en graphite, provenant d'un rouleau 6. Des moyens de tirage vertical, non représentés, agissent sur la partie supérieure 9 du ruban 4 de façon à le faire déplacer de bas en haut dans le bain, dans le sens de la flèche 10. Le déplacement du ruban 4 est guidé par des galets 5 et 8. Les dimensions de l'ouverture 7 sont déterminées de façon que le ménisque de raccordement du silicium liquide, entre le ruban 4 et le fond du récipient 1, soit stable au cours du déplacement du ruban, afin d'éviter toute fuite de silicium liquide par l'ouverture 7. On recouvre ainsi toute la surface du ruban 4 d'une mince pellicule de silicium polycristallin.

On coupe alors transversalement le ruban 4 recouvert de silicium de façon à obtenir des tronçons de longueur prédéterminée (par exemple, de l'ordre de vingt centimètres). Puis on découpe deux bords longitudinaux de chaque élément, sur une faible largeur. La découpe peut être effectuée par jet de sable ou par faisceau laser.

On obtient ainsi des bandes telles que 11 (voir figure 2), comportant deux couches de silicium 12 et 13 appliquées respectivement sur les deux faces principales d'une feuille de carbone. Ces couches sont d'épaisseurs sensiblement égales entre elles, par exemple de l'ordre de 60 microns. Comme il est visible sur la figure 2, le carbone est dénudé aussi bien sur les tranches longitudinales 14 de la bande 11 que sur les tranches transversales 15.

On dispose alors les bandes 11 dans un four à 1 000 °C sous oxygène. Dans chaque bande, la feuille de carbone brûle, la combustion s'amorçant sur les tranches où le carbone est directement en contact avec l'oxygène. Après la combustion, les deux couches 12 et 13 se trouvent séparées l'une de l'autre et forment deux feuilles de silicium qui peuvent être utilisées pour la fabrication de photopiles solaires.

L'élimination du carbone peut aussi s'effectuer par oxydation chimique, en plongeant les bandes 11 dans un mélange d'acide sulfurique et d'eau oxygénée par exemple, ou par oxydation anodique en présence d'un électrolyte du type solution de soude. Dans ce dernier cas, l'élimination du carbone s'effectue à la température ambiante.

Le procédé décrit ci-dessus présente, par rapport au procédé connu qui conduit à l'obtention de plaquettes de silicium comprenant un support de carbone, les avantages suivants :

— la capacité de production de plaquettes est multipliée par deux, puisqu'on obtient deux feuilles de silicium pour chaque bande 11,

— l'incidence du coût du ruban de carbone dans le prix de revient de la plaquette est réduite d'un facteur deux,

— la consommation de silicium est également réduite d'un facteur de l'ordre de deux,

— les plaquettes obtenues sont entièrement en silicium ce qui simplifie la technologie de réalisations de photopiles solaires, et sont compatibles avec la réalisation de photopiles minces de fabrication moins onéreuse et de rendement plus élevé.

Le procédé d'oxydation peut aussi s'effectuer en continu. Dans ce cas on ne découpe pas le ruban transversalement, et l'amorce de la combustion n'a lieu que sur les bords latéraux du ruban.

**Revendications**

1. Procédé de fabrication de feuilles de silicium polycristallin pour photopiles solaires, consistant :
— à déposer une pellicule de silicium polycristallin sur toute la surface d'un ruban de carbone (4) par déplacement du ruban dans un bain (2) de silicium fondu, caractérisé en ce qu'il consiste en outre :
— à découper les bords du ruban (4) recouvert de la pellicule de silicium de façon à obtenir une bande (11) comportant deux couches de silicium (12, 13) appliquées respectivement sur les deux faces principales d'une feuille de carbone (14)
— et à éliminer la feuille de carbone par oxydation chimique ou électrochimique de manière à obtenir deux feuilles de silicium.

2. Procédé selon la revendication 1, caractérisé en ce que l'élimination de la feuille de carbone (14) est effectuée en disposant la bande (11) dans un fluide oxydant.

3. Procédé selon la revendication 1, caractérisé en ce que l'élimination de la feuille de carbone (14) est effectuée par oxydation anodique en disposant la bande (11) dans un électrolyte.

4. Procédé selon la revendication 2, caractérisé en ce que le fluide oxydant est un liquide.

5. Procédé selon la revendication 2, caractérisé en ce que le fluide oxydant est un gaz.

6. Procédé selon la revendication 5, caractérisé en ce que, le gaz étant de l'oxygène, l'élimination est réalisée à une température de l'ordre de 1 000 °C.

7. Procédé selon la revendication 1, caractérisé en ce que le déplacement du ruban (4) de carbone dans le bain de silicium fondu s'effectue verticalement à travers une fine ouverture (7) ménagée dans le fond d'un récipient (1) contenant le bain (2) de silicium fondu.

8. Procédé selon la revendication 1, caractérisé en ce que le découpage des bords du ruban comprend un découpage des deux bords longitudinaux du ruban et un découpage transversal de façon à obtenir ladite bande.

9. Procédé selon la revendication 1, caractérisé en ce que le découpage des bords du ruban comprend un découpage des deux bords longitudinaux du ruban, et qu'il comporte en outre, après l'élimination de la feuille de carbone, un découpage transversal, de façon à séparer lesdites feuilles.

**Claims**

1. A process for manufacturing polycrystalline silicon sheets for use in solar cells, consisting in :
— depositing a film of polycrystalline silicon over the entire surface of a carbon strip (4) by passing the strip through a bat (2) of molten silicon, characterized in that it further consists in :
— cutting off the edges of said strip (4) when covered with the silicon film so as to obtain a strip (11) comprising a respective layer (12, 13) of silicon on each side of a carbon sheet (14), and
— eliminating the carbon sheet by chemical or electrochemical oxidation so as to obtain two sheets of silicon.

2. A process according to claim 1, characterized in that the carbon sheet (14) is eliminated by placing the strip (11) in an oxidizing fluid.

3. A process according to claim 1, characterized in that the carbon sheet (14) is eliminated by placing the strip (11) in an electrolyte to bring about anodic oxidization.

4. A process according to claim 2, characterized in that the oxidizing fluid is a liquid.

5. A process according to claim 2, characterized in that the oxidizing fluid is a gas.

6. A process according to claim 5, characterized in that the gas is oxygen and elimination is effected at a temperature of approximately 1 000 °C.

7. A process according to claim 1, characterized in that the carbon strip (4) is moved vertically through the bath of molten silicon through a narrow aperture (7) in the bottom of a container (1) in which the bath (2) of molten silicon is contained.

8. A process according to claim 1, characterized in that the tapes are formed by cutting the two longitudinal edges of the strip and by cutting the two ends of the strip transversally.

9. A process according to claim 1, characterized in that the cutting of the edges of the strip comprises the cutting of the longitudinal edges of the strip, and that it further includes, after the removal of the carbon sheet, a transversal cut, so as to separate said sheets.

**Patentansprüche**

1. Verfahren zur Herstellung von polykristallinen Siliziumblättern für Solarzellen, bei dem ein polykristalliner Siliziumfilm auf die gesamte Oberfläche eines Kohlenstoffbandes (4) durch Fortbewegen desselben in einem Bad (2) geschmolzenen Siliziums aufgebracht wird, dadurch gekennzeichnet, daß weiter :
— die mit dem Siliziumfilm bedeckten Ränder des Bandes (4) abgeschnitten werden und so ein Band (11) erhalten wird, welches zwei Siliziumschichten (12, 13) aufweist, die auf den entsprechenden beiden Grundseiten eines Kohlenstoffblattes (14) aufgebracht sind,
— und daß das Kohlenstoffblatt durch chemische oder elektrochemische Oxidation entfernt wird, so daß zwei Siliziumblätter erhalten werden.

2. Verfahren nach Anspruch 1, dadurch gekennzeichnet, daß das Kohlenstoffblatt (14) dadurch entfernt wird, daß das Band (11) einem oxidierenden Fluid ausgesetzt wird.

3. Verfahren nach Anspruch 1, dadurch gekennzeichnet, daß das Kohlenstoffblatt (14) durch anodische Oxidation entfernt wird, indem das Band (11) einem Elektrolyten ausgesetzt wird.

4. Verfahren nach Anspruch 2, dadurch gekennzeichnet, daß daß oxidierende Fluid eine Flüssigkeit ist.

5. Verfahren nach Anspruch 2, dadurch gekennzeichnet, daß das oxidierende Fluid ein Gas ist.

6. Verfahren nach Anspruch 5, dadurch gekennzeichnet, daß als Gas Sauerstoff verwendet wird und daß die Beseitigung bei einer Temperatur von ca 1 000 °C erfolgt.

7. Verfahren nach Anspruch 1, dadurch gekennzeichnet, daß die Bewegung des Kohlenstoffbandes (4) im Siliziumschmelzbad in der Senkrechten durch eine feine Öffnung (7) im Behälterboden (1) des Siliziumschmelzbades (2) erfolgt.

8. Verfahren nach Anspruch 1, dadurch gekennzeichnet, daß sich das Abschneiden der Bandränder auf ein Abschneiden der beiden Längsränder des Bandes und auf ein quer dazu verlaufendes Abschneiden erstreckt, so daß auf diese Weise das genannte Band erhalten wird.

9. Verfahren nach Anspruch 1, dadurch gekennzeichnet, daß das Abschneiden der Bandränder ein Abschneiden der beiden Längsränder und, nach Beseitigung des Kohlenstoffblattes, ein quer dazu verlaufendes Abschneiden umfaßt, so daß auf diese Weise die genannten Blätter getrennt werden.

FIG.1

FIG. 2